# EUROPEAN PATENT SPECIFICATION

(11) **EP 4 484 977 B1**
(45) Date of publication and mention of the grant of the patent: **04.11.2026**
(21) Application number: 24179385.0
(22) Date of filing: 31.05.2024
(51) Int. Cl.: G01R 31/3185

(54) **TEST PATTERN GENERATION USING MULTIPLE SCAN ENABLES**
TESTMUSTERERZEUGUNG MIT MEHREREN SCAN-AKTIVIERUNGEN
GÉNÉRATION DE MOTIFS DE TEST À L'AIDE DE MULTIPLES VALIDATIONS DE BALAYAGE

(30) Priority: 20.06.2023 US 202318338082
(43) Date of publication of application: 01.01.2025
(73) Proprietor: STMicroelectronics International N.V., 1228 Plan-les-Ouates, Geneva (CH)
(72) Inventor: VATS, Shiv Kumar, 201308 Greater Noida (IN); SRIVASTAVA, Umesh Chandra, 201306 Greater Noida (IN); SRINIVASAN, V Narayanan, 201310 Greater Noida (IN)
(74) Representative: Buzzi, Notaro & Antonielli d'Oulx S.p.A.

(56) References cited:
- US-A1- 2018 031 631
- US-A1- 2022 244 308
- US-B1- 11 604 221
- AHMED NISAR ET AL: "Local at-speed scan enable generation for transition fault testing using low-cost testers", IEEE TRANSACTIONS ON COMPUTER-AIDED DESIGN OF INTEGRATED CIRCUITS AND SYSTEMS, IEEE, USA, vol. 26, no. 5, 1 May 2007 (2007-05-01), pages 896 - 906, XP011778270, ISSN: 0278-0070, [retrieved on 20180518], DOI: 10.1109/TCAD.2007.8361583

## Description

### TECHNICAL FIELD

The present disclosure relates generally to test pattern generation for the testing of integrated circuits. One or more embodiments relates to structures of integrated circuits with design for testability (DFT) functionality implemented with scan chains, and methods of operation thereof.

### BACKGROUND

With the rapid increase in the quantity of circuit elements in integrated circuits and the equally rapid decrease in the size of these circuit element, developing efficient and effective testing methods for integrated circuits has become more and more important. Additionally, more and more elements of integrated circuits are becoming internal and the number of logic level are increasing (e.g., in complex implementations such as a system on a chip - SoC). Automatic test pattern generation (ATPG) can be used to improve testing efficiency as well as test coverage of possible faults. However, the sheer magnitude and complexity of modern integrated circuits increases the pattern count and the test time.

Many different types of faults must be tested for in order to ensure reliable operation of the integrated circuit. One particular category of faults involving signal timing includes faults such as path delay faults and transition delay faults. Because identifying timing faults depends on the system timing, these faults must be tested at system speeds. Such "at-speed testing" launches test patterns along a path (e.g., through combinational logic that is being tested) and captures the result after a time defined by system timing (e.g., one or more system clock cycles).

Before launching, the test pattern is shifted into test registers (e.g., scan flip flops that are configured to operate in either functional mode or scan mode depending on the signal received at a scan enable input). During the shift, the scan flip flops are operating in scan mode. Prior to capture, the scan flip flops must be in functional mode, which can create timing issues for the transition of the scan enable signal. There are two basic methods of ensuring that the scan enable signal fully transitions between the last shift and the capture: the launch-off-capture (LOC) method and the launch-off-shift (LOS) method.

In the LOC method, there is a dead cycle after the last shift to allow the scan enable signal to transition at a slower speed than the system clock. This allows the test clock (used for shift pulses) to be at a lower speed than the system clock. However, LOC sacrifices control because the scan enable signal transitions the scan flip flops to functional mode (capture mode) before the launch pulse. As a result, the launch is based off of functional logic causing the ATPG patterns to be sequential, which increases pattern count.

On the other hand, the LOS method launches the pattern on the last shift, requiring the scan enable signal to transition between the launch pulse and the capture pulse (two at-speed pulses). In contrast to LOC, the scan enable signal keeps the scan flip flops in scan mode (launch mode) during the launch pulse in LOS. This affords more control, but has stringent timing requirements that can be difficult or impossible to meet. Summary

One or more embodiments facilitate providing a desirable at-speed testing method that reduces the pattern count compared to LOC without the stringent timing requirements of LOS.

In accordance with an embodiment of the invention, an integrated circuit includes a first set of scan flip flops, a circuit under test, a second set of scan flip flops, and a controller. Each of the scan flip flops of the first set includes a scan enable input coupled to a first scan enable signal. A circuit under test includes logic elements downstream of the first set of scan flip flops. The second set of scan flip flops includes at least one scan flip flop downstream of the logic elements. Each of the scan flip flops of the second set includes a scan enable input coupled to a second scan enable signal. The controller is configured to test the logic elements by shifting test patterns into the first set while asserting both the first scan enable signal and the second scan enable signal, launching the test patterns, and capturing results from the second set while continuing to assert the first scan enable signal and deasserting the second scan enable signal.

In accordance with another embodiment of the invention, an integrated circuit includes a circuit under test including initiator logic elements and target logic elements, a first scan chain of scan flip flops including the initiator logic elements, a second scan chain of scan flip flops including the target logic elements, and a controller configured to test the circuit under test. Each scan flip flop of the first scan chain includes a scan enable input coupled to a first scan enable signal. Each of the scan flip flops of the second scan chain includes a scan enable input coupled to a second scan enable signal. The controller is configured to test the circuit under test by shifting a first test pattern into the first scan chain while both the initiator logic elements and the target logic elements are operating in launch mode, launching the first test pattern, and capturing results from the second scan chain while the initiator logic elements are operating in launch mode and the target logic elements are operating in capture mode.

In accordance with still another embodiment of the invention, a method of testing an integrated circuit includes shifting a first test pattern into a first set of scan flip flops of the integrated circuit upstream of first logic elements of the integrated circuit while asserting both a first scan enable signal and a second scan enable signal. Each of the scan flip flops of the first set include a scan enable input coupled to the first scan enable signal. The method further includes deasserting the second scan enable signal while continuing to assert the first scan enable signal, launching the first test pattern, and capturing results from a second set of scan flip flops of the integrated circuit downstream of the first logic elements while the first scan enable signal is asserted and the second scan enable signal is deasserted. Each of the scan flip flops of the second set include a scan enable input coupled to the second scan enable signal.

Document US 2018/031631 A1 discusses a logic built-in self-test (LBIST) circuit implements a pipeline scan enable launch on shift (LOS) feature. A first scan chain flip-flop has a scan enable input configured to receive a first scan enable signal. A logic circuit has a first input coupled to a data output of the first scan chain flip-flop and a second input coupled to receive the first scan enable signal. A second scan chain flip-flop has a scan input coupled to a scan output of the first scan chain flip-flop. A scan enable input of the second scan chain flip-flop is coupled to receive a second scan enable signal generated at an output of the logic circuit. The first and second scan chain flip-flops are clocked by a same clock signal.

### BRIEF DESCRIPTION OF THE DRAWINGS

For a more complete understanding of the present invention, and the advantages thereof, reference is now made to the following description taken in conjunction with the accompanying drawings, in which:

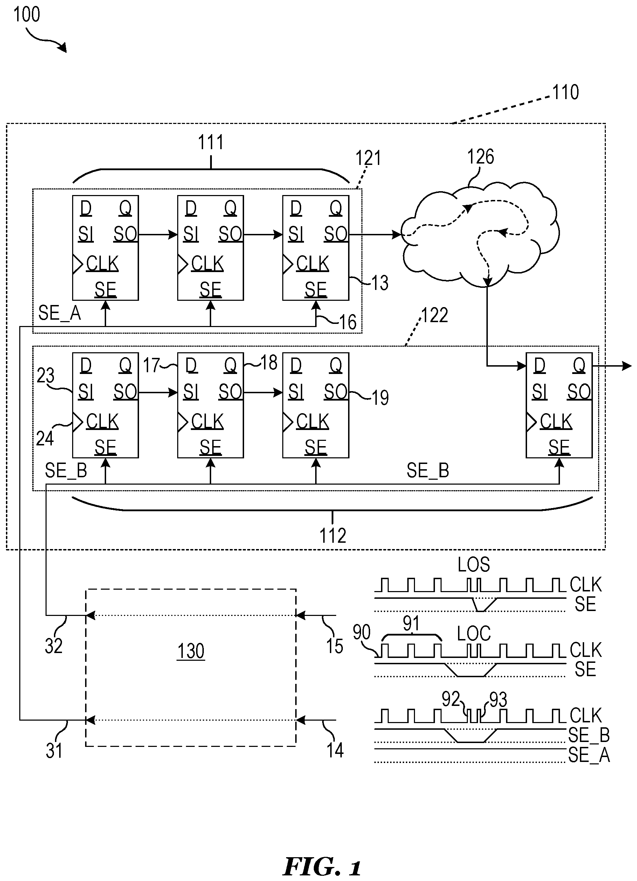

Figure 1 illustrates an example integrated circuit with DFT functionality including a first set of scan flip flops coupled to a first scan enable signal and a second set of scan flip flops coupled to a second scan enable signal in accordance with embodiments of the invention;

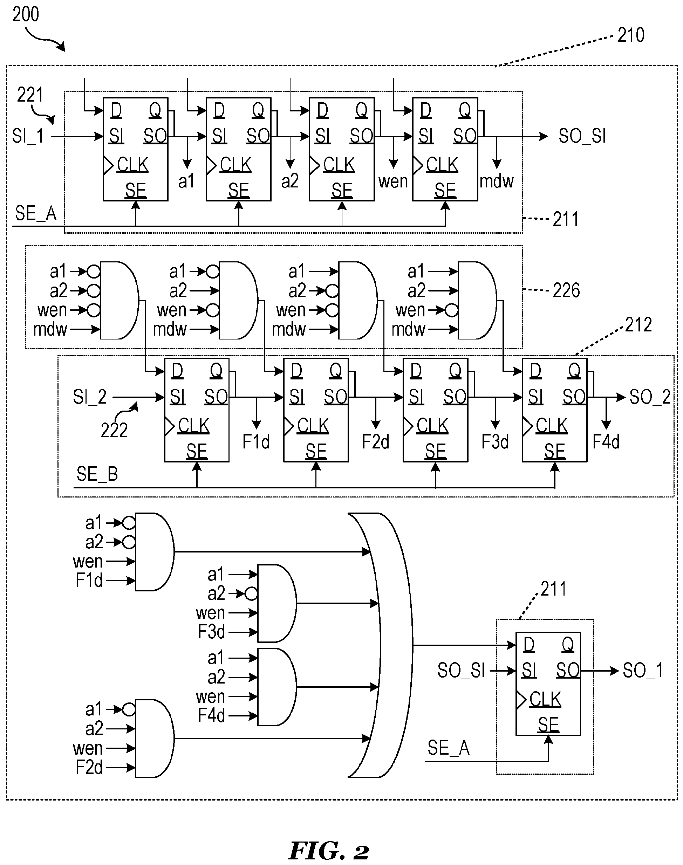

Figure 2 illustrates another example integrated circuit with DFT functionality including a first scan chain coupled to a first scan enable signal and a second scan chain coupled to a second scan enable signal where the integrated circuit includes a first in, first out circuit in accordance with embodiments of the invention;

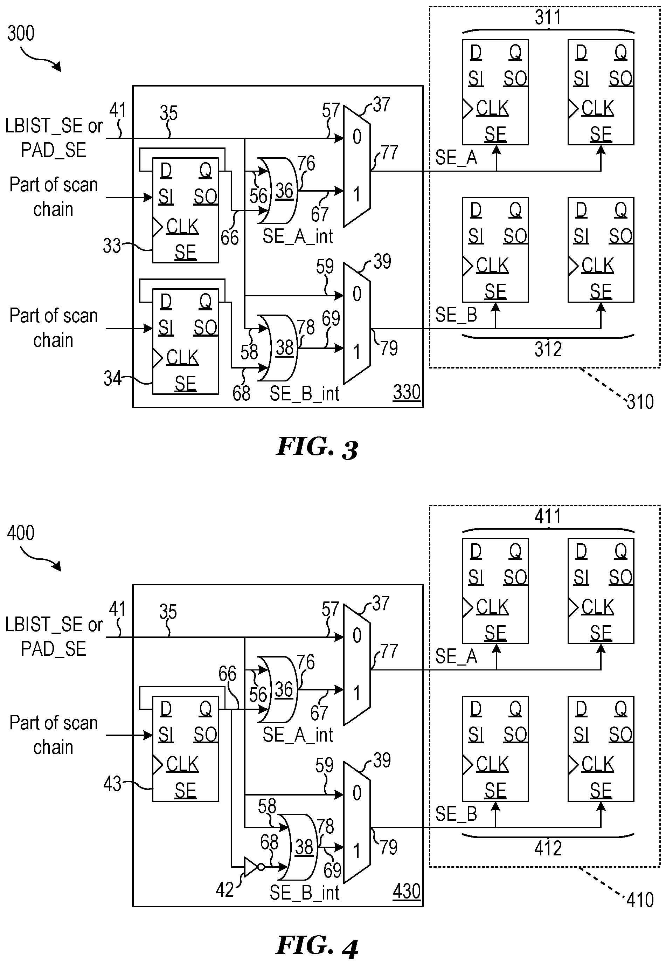

Figure 3 illustrates an example integrated circuit with DFT functionality including a controller having a scan enable input that controls a first scan enable signal coupled to a first set of scan flip flops and also controls a second scan enable signal coupled to a second set of scan flip flops in accordance with embodiments of the invention;
Figure 4 illustrates another example integrated circuit with DFT functionality including a controller having a scan enable input that controls a first scan enable signal coupled to a first set of scan flip flops and also controls a second scan enable signal coupled to a second set of scan flip flops in accordance with embodiments of the invention;

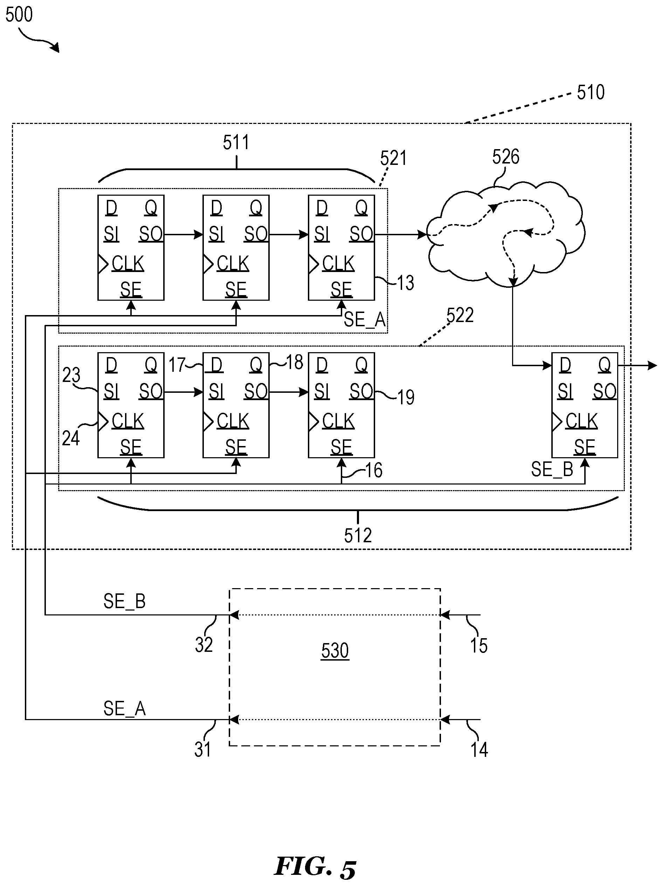

Figure 5 illustrates an example integrated circuit with DFT functionality including a first set of scan flip flops coupled to a first scan enable signal and a second set of scan flip flops coupled to a second scan enable signal in accordance with embodiments of the invention;

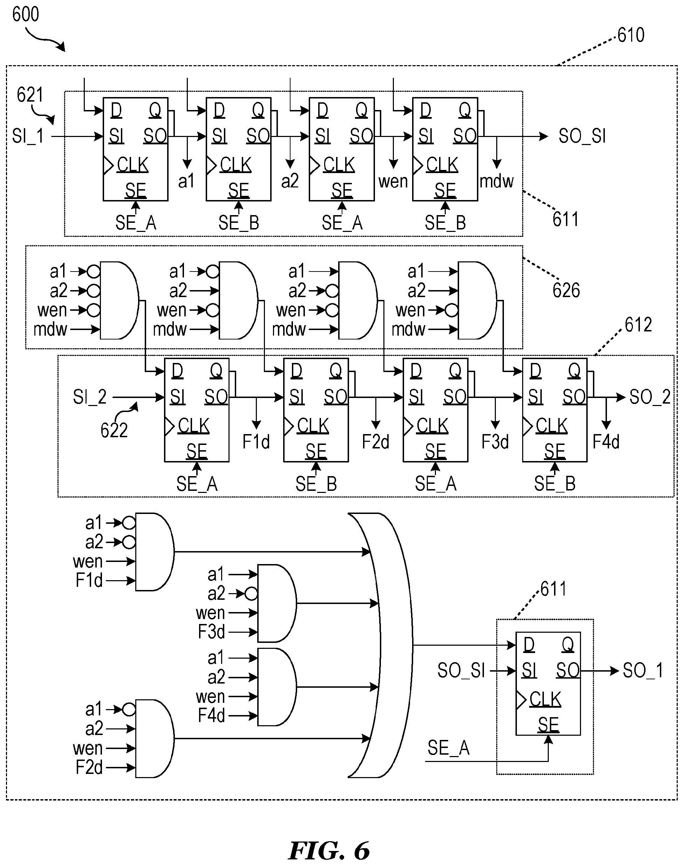

Figure 6 illustrates another example integrated circuit with DFT functionality including a first set of scan flip flops coupled to a first scan enable signal and a second set of scan flip flops coupled to a second scan enable signal where the integrated circuit includes a first in, first out circuit in accordance with embodiments of the invention;

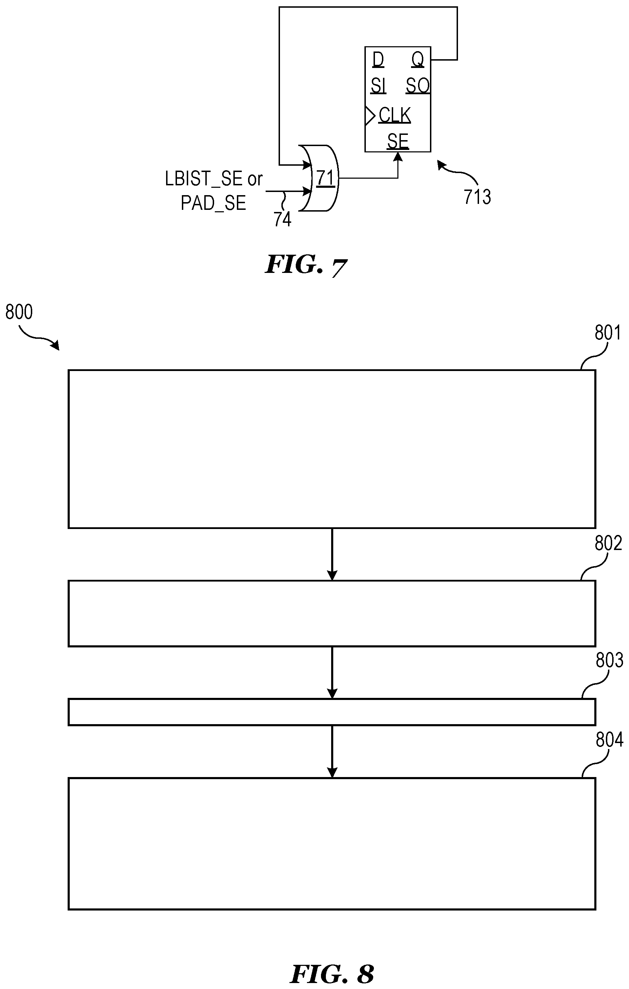

Figure 7 illustrates an example scan flip flop of an integrated circuit with DFT functionality where the scan flip flop has a localized scan enable in accordance with embodiments of the invention; and
Figure 8 illustrates an example method of testing an integrated circuit with DFT functionality including a first set of scan flip flops coupled to a first scan enable signal and a second set of scan flip flops coupled to a second scan enable signal in accordance with embodiments of the invention.

Corresponding numerals and symbols in the different figures generally refer to corresponding parts unless otherwise indicated. The figures are drawn to clearly illustrate the relevant aspects of the embodiments and are not necessarily drawn to scale. The edges of features drawn in the figures do not necessarily indicate the termination of the extent of the feature.

### DETAILED DESCRIPTION OF ILLUSTRATIVE EMBODIMENTS

The making and using of various embodiments are discussed in detail below. It should be appreciated, however, that the various embodiments described herein are applicable in a wide variety of specific contexts. The specific embodiments discussed are merely illustrative of specific ways to make and use various embodiments, and should not be construed in a limited scope. Unless specified otherwise, the expressions "around", "approximately", and "substantially" signify within 10%, and preferably within 5% of the given value or, such as in the case of substantially zero, less than 10% and preferably less than 5% of a comparable quantity.

As electronic circuits (e.g., integrated circuits such as SoCs) grow in size and become more complex (e.g., with increased logic levels), the number of test patterns used to test the electronic circuits increases. This increase in pattern count results in a corresponding increase in test time. At the same time, there is also a decrease in the test coverage (e.g., design for testability, DFT coverage) due to poor controllability of conventional at-speed testing methodologies. The increased circuit complexity also leads to physical design constraints in order to meet high fanout non-functional paths at-speed which can further reduce test coverage. These issues become more and more important as the size and complexity of integrated circuits, such as SoCs, increases.

While DFT tools are also getting more advanced, there are still many times where tool limitations are reached regarding high pattern count and huge pattern generation time. Designs using the launch-off-capture (LOC) approach to launch and capture have a higher pattern count due to reduced control while the launch-off-shift(LOS) approach has a stringent (frequently hardly feasible) timing requirement. Power consumption is another area that can affect pattern count. For example, the dependency on the tool to reduce the capture power can also result in heavy pattern inflation. Therefore, there is a recognized problem that although current DFT tools are advanced, there are still undesirable limitations. So, methods that are both timing friendly and that also reduce the pattern count are desirable.

Conventional solutions to pattern generation are the LOC and the LOS methods. In LOS, the scan enable signal is "high" (that is, the scan flip flops are in scan mode) between the launch pulse and the capture pulse. The scan enable signal will transition to "low" (functional mode) between the launch pulse and the capture pulse (the strict at-speed timing requirement), but the scan enable signal is asserted during launch (based on the scan input - SI of a scan flip flop). This allows more control over downstream logic allowing the tool to generate patterns easier and pattern count is reduced. However, the at-speed clock (e.g. the system clock), that defines the duration between the launch pulse and the capture pulse, may be very high relative to the test clock (e.g. a 1 GHz system clock requiring less than 1 ns transition compared to a 50 MHz test clock). It can be very difficult to meet this transition timing requirement on the scan enable path (e.g., because of high fan out transitioning). For this reason, the conventional LOS method is not feasible in many circumstances.

The LOC method counters the timing requirements on the scan enable path by generating patterns that allow transitioning the scan enable signal to low prior to the launch pulse during a dead test cycle (or more than one). Because the scan enable signal is "low" (functional mode) during the launch pulse, the launch is based on functional logic (e.g. a functional input D of a scan flip flop). This control using only upstream logic limits the ability of target faults, such as path delay faults and transition delay faults. Downstream logic will be captured at a functional input of another scan flip flop. Because of the reliance on upstream functional logic to control downstream logic, the conventional LOC method decreases tool flexibility and increases the pattern count which in turn reduces coverage. That is conventional LOC has limitations due to increased pattern count and reduced DFT coverage.

In various embodiments, the integrated circuits with DFT functionality described herein include separate scan enables simultaneously used during the launch and capture of a test pattern. For example, a first set of scan flip flops is coupled to a first scan enable signal while a second set of scan flip flops is coupled to a second scan enable signal. The sets of scan flip flops may be chosen based on knowledge of a given design (e.g., by identifying similarly situated elements as initiators or targets in the testing of certain logic elements). Alternatively, some or all of the sets of scan flip flops may be connected without considering design details (e.g., according to a script during scan insertion).

A controller (internal or external) may be configured to test logic elements by shifting in a test pattern while the scan flip flops are in scan mode (launch mode). For example, the first scan enable signal and the second scan enable signal may be asserted while shifting in the test pattern. The controller also may be configured to launch the test pattern and capture the results from the second set of scan flip flops while the second set is in functional mode (capture mode) and the first set remains in scan mode (launch mode). For example, the second scan enable signal may be deasserted and the first scan enable signal may be asserted.

The embodiments described herein may reduce or eliminate the previously discussed disadvantages of conventional pattern generation methods. For example, the embodiment integrated circuits may provide efficient scan methods by ensuring pattern count reduction to reduce test time (e.g. compared with conventional LOC methods) while simultaneously avoiding stringent timing requirements on scan enable paths (e.g., compared with conventional LOS methods). In other words, the embodiment launch and capture methods and corresponding integrated circuits described herein may advantageously provide the benefits of conventional LOS and LOC while reducing or removing their disadvantages.

The embodiments described herein may also advantageously be implemented in any project with scan implementation, such as an SoC or other integrated circuit. Various embodiments, such as those that take the specifics of a given design into consideration during scan insertion, may be beneficial for use in future designs while some embodiments, such as those that use tool options for scan insertion without considering deign specifics may have the advantage of being immediately used in current devices as well as in future devices.

Embodiments provided below describe various integrated circuits with DFT functionality, and in particular, DFT functionality that includes a set of scan flip flops coupled to a scan enable signal asserted during shift and deasserted during capture, and that includes another set of scan flip flops coupled to a different scan enable signal asserted during both shift and capture. The following description describes the embodiments. Figure 1 is used to describe an example integrated circuit. An example integrated circuit with a circuit under test that includes a first-in first-out (FIFO) circuit is described using Figure 2. Two example integrated circuits with a controller configured to simultaneously drive a first scan enable signal and a second scan enable signal are described using Figures 3 and 4. Another integrated circuit is described using Figure 5. Another example integrated circuit with a circuit under test that includes a FIFO circuit is described using Figure 6. An example scan flip flop is described using Figure 7. An example method of testing an integrated circuit is described using Figure 8.

Figure 1 illustrates an example integrated circuit with DFT functionality including a first set of scan flip flops coupled to a first scan enable signal and a second set of scan flip flops coupled to a second scan enable signal in accordance with embodiments of the invention.

Referring to Figure 1, an integrated circuit 100 includes a circuit under test 110, a first set of scan flip flops 111 and a second set of scan flip flops 112. The circuit under test 110 includes logic elements 126 that are to be tested using the first set of scan flip flops 111 and the second set of scan flip flops 112. The circuit under test 110 may be any circuit that includes logic elements, such as a FIFO circuit, Joint Test Action Group (JTAG) state machine, memory circuit, bus registers and peripheral read/write registers, and the like. The circuit under test 110 may include various combinations of combinational logic elements and sequential logic elements.

The first set of scan flip flops 111 may be similarly situated within the design. For example, the first set of scan flip flops 111 may be initiator logic elements with respect to the logic elements 126 (e.g., located upstream of the logic elements 126). Similarly, the second set of scan flip flops 112 may be target logic elements with respect to the logic elements 126 (e.g., located downstream of the logic elements 126). In various embodiments, the first set of scan flip flops 111 and the second set of scan flip flops 112 are sequential logic elements coupled to combinational logic elements of the logic elements 126. The first set of scan flip flops 111 may be (or be part of) a first scan chain 121 (e.g. of initiator logic elements) while the second set of scan flip flops 112 may be (or be part of) a second scan chain 122 (e.g. of target logic elements separate from the first scan chain 121), as shown. Alternatively, one or more scan flip flops with different scan enable signals may be part of the same chain (that is, a mixed chain).

Some or all of the scan flip flops may have a function during normal operation in addition to a test function as part of a scan chain. For example, when the circuit under test 110 includes a FIFO circuit, the first set of scan flip flops 111 may be configured to write to the FIFO circuit (and read from the FIFO) and second set of scan flip flops 112 may include a FIFO shift register (functional logic). As another example, when the circuit under test 110 includes a JTAG state machine, the first set of scan flip flops 111 may include a common data shift register while the second set of scan flip flops 112 may include multiple test data registers.

In another example, when the circuit under test 110 includes a memory circuit, the first set of scan flip flops 111 may be configured to write (and/or read) from memory cells of the memory circuit (e.g., a BIST) while the second set of scan flip flops 112 may include the memory cells (e.g., bits). In yet another example, when the circuit under test 110 includes a bus interface and a peripheral interface, the first set of scan flip flops 111 may include the bus interface and the second set of scan flip flops 112 may include the peripheral interface.

Each scan flip flop 13 includes a functional input 17 (D input) and a functional output 18 (Q output). In addition, each scan flip flop 13 includes a scan input 23 (SI input) and a scan output 19 (SO output). Specifically, a scan enable input 16 (SE input) of each scan flip flop 13 selects between the functional input 17 and the scan input 23. Conceptually, the scan flip flop 13 is shown to have two separate outputs. However, in practice the scan flip flop 13 may have only one output (Q output) to which the selected input (functional input 17 or scan input 23) is propagated with pulses to a clock input 24 (CLK input).

The logic elements 126 are located downstream of the first set of scan flip flops 111. In one embodiment, the logic elements 126 are combinational logic elements. The logic elements 126 may also be a single logic element (such as a single logic gate, etc.). At least one of the second set of scan flip flops 112 is located downstream of the logic elements 126, as shown.

The integrated circuit 100 includes a first scan enable signal 31 and a second scan enable signal 32 that are separately controllable. The scan enable input 16 of each of the scan flip flops of the first set of scan flip flops 111 is coupled to the first scan enable signal 31 while the scan enable input 16 of each of the second set of scan flip flops 112 is coupled to the second scan enable signal 32.

The first scan enable signal 31 (shown as SE_A) and the second scan enable signal 32 (shown as SE_B) may be coupled to dedicated external connections, such as a first test pin 14 and second test pin 15, as shown. For example, the first test pin 14 and the second test pin 15 may be test pads of the integrated circuit 100. In this way, the first scan enable signal 31 and the second scan enable signal 32 may be controlled externally (e.g., entirely by external test equipment). Alternatively, the first test pin 14 and the second test pin 15 may be combined into a single external connection (e.g., test pin/pad), or the first scan enable signal 31 and the second scan enable signal 32 may be controlled entirely internally (as in logic built-in self-test - LBIST, for example). The first scan enable signal 31 and the second scan enable signal 32 may be dynamically toggled by the tool during testing.

A controller 130 may be included to control some or all aspects of the shift, launch, and capture phases of the testing process. For example, the controller 130 may be configured to control timing and transitions of the first scan enable signal 31 and the second scan enable signal 32. In the case where the first scan enable signal 31 and the second scan enable signal 32 are separate and externally provided, the controller 130 may be configured to control the generation of testing pulses, such as shift pulses 91, a launch pulse 92, and a capture pulse 93 for each test pattern. The test pulses may also be externally driven, (which may be made possible by the relaxed timing requirements when compared to the stringent timing settings of conventional LOS, for example).

When the first scan enable signal 31 and the second scan enable signal 32 are combined (whether as a single external connection or as a single internal connection, for instance), the controller 130 may be configured to control the first scan enable signal 31 and the second scan enable signal 32 using, for example, a combination of scan flip flops, logic gates, multiplexers, and/or inverters. These scan flip flops may be part of one or more scan chains (e.g., a control scan chain) to facilitate control over the first scan enable signal 31 and the second scan enable signal 32. The controller 130 may also be configured to test the logic elements 126 by shifting test patterns into the scan flip flops, launching the test patterns, and capturing results from the scan flip flops.

The partitioning of the scan flip flops into separate groups connected to separate scan enables may allow advantageous timing attributes during shift, launch, and capture. For example, a test pattern may be shifted into the scan flip flops (e.g., the first set of scan flip flops 111 while both the first scan enable signal 31 and the second scan enable signal 32 are asserted (e.g., high "1") placing the first set of scan flip flops 111 and the second set of scan flip flops 112 in scan mode (launch mode). Because there are two separate scan enable signals, the second scan enable signal 32 can be deasserted (e.g., low "0") prior to the launch pulse 92 placing the second set of scan flip flops 112 in functional mode (capture mode) and the test pattern can be launched with the first set of scan flip flops 111 (upstream scan flip flops, the initiator logic elements, for example) in launch mode. The results can then be captured from one or more of the second set of scan flip flops 112 in capture mode (downstream of the logic elements 126, the target logic elements, for example). Thus, the launch advantage and corresponding flexibility and pattern reduction benefits over conventional LOC are obtained without the stringent timing requirements of conventional LOS. Additionally, the ability to launch with upstream flip flops in launch mode may advantageously allow the test patterns to be only combinational test patterns which may reduce pattern count.

When the first set of scan flip flops 111 and the second set of scan flip flops 112 are selected based on design knowledge a greater pattern reduction may advantageously be gained. For example, using design knowledge (e.g. by reading an analyzed the design), initiator and target logics may be separated into different partitions at the register transfer level (RTL) scan insertion level and different scan enable signals may be connected to them, (either external or internal). The scan flip flops can be inserted as different scan chains (as shown). This may be suitable for first device iterations (e.g. of a product family)/first cut of a product because partitioning is possible.

Various criteria may be used to divide the logic of a given design in categories for the connection of different scan enable signals. For example, similar types of logic may be grouped, spatially or functionally similar logic may be grouped (e.g., blocks of logic), etc. In some cases, the categorizing by type of logic may provide better coverage because similarly situated scan flip flops will be connected to the same scan enable signal. In some cases, tools can be designed to stitch related logic into single scan chain based on their clock and hierarchy. For example, master (e.g. initiator) logic elements and slave (e.g. target) logic elements may already be placed in different hierarchies, allowing the separate scan enable signals to be connected to already existing scan chains.

With the initiator/target method, the tool can advantageously always (or at least the majority of the time) launch similar to LOS and capture similar to LOC which may providing more coverage for the same pattern count then conventional LOC and the scan enable path is constant between the launch pulse 92 and the capture pulse 93 (there is no scan enable toggle between two at-speed pulses as in LOS). Alternatively, (as discussed in more detailed in Figures 5-7) some or all of the scan flip flops can be connected without considering the design and the tool can use launch similar to LOS with capture similar to LOC when possible and conventional LOC otherwise. This still may have the benefit of providing more coverage for the same pattern count then using only conventional LOC and the scan enable path still remains constant between the launch pulse 92 and the capture pulse 93. Compared to the initiator/target method, the mixed method may take slightly more patterns for the same coverage, but without involving any specific design knowledge. Therefore, the decision of how to connect the separate scan enable signals is a choice that may be made by according to the specific requirements of a given application.

Timing diagrams showing a clock signal 90 and a corresponding scan enable signal for conventional LOS and conventional LOC are provided for comparison with the embodiments described herein, that use multiple (e.g., two) scan enable signals to launch similar to LOS while capturing similar to LOC. As shown, shifting a test pattern uses test clock pulses (shift pulses 91, at a slower clock than the system clock) and launching the test pattern and capturing the results uses two at-speed pulses (the launch pulse 92 and the capture pulse 93, faster than the test clock, and can be as fast as the system clock).

In LOS, the scan enable signal is high during the launch pulse 92, but the fall time (plus logic settle time) of the scan enable path must be shorter than the time between the launch pulse 92 and the capture pulse 93 (as short as 1 ns or even faster). In LOC, there is a delay between the last of the shift pulses 91 and the launch pulse 92 to allow the scan enable signal to transition, but the scan enable signal is low during the launch pulse 92. In contrast, when two scan enable signals SE_A and SE_B are used, the scan enable signal for the upstream scan flip flops (first scan enable signal 31, SE_A) is high during the launch pulse 92 and the scan enable signal for the scan flip flops used for capture (downstream scan flip flops) is low during the capture pulse 93 while still allowing for a delay between the last of the shift pulses 91 and the launch pulse 92.

The role of the sets of scan flip flops (e.g., initiator versus target) may switch depending on the specifics of what is being tested. In one specific example, when memory is being tested, both read and write are tested. To test write functionality, initiator logic that is configured to write to the memory (e.g. a BIST) may play the initiator role while the memory itself (memory cells) may play the target role. However, to test read functionality, the memory may play the initiator role while the BIST plays the target role. In this case, the timing diagrams for the SE_A and SE_B signals would be switched because the roles are switched. That is, what was upstream for the write test is now downstream and so SE_A would be made low prior the launch pulse 92 and SE_B would remain high. That is, the initiator logic elements and the target logic elements would both be in launch mode during shift, and the initiator logic elements would be transitioned to capture mode prior to launch and be in capture mode during capture while the target logic elements continue operating in launch mode.

Figure 2 illustrates another example integrated circuit with DFT functionality including a first scan chain coupled to a first scan enable signal and a second scan chain coupled to a second scan enable signal where the integrated circuit includes a FIFO circuit in accordance with embodiments of the invention. The integrated circuit of Figure 2 may be a specific implementation of other integrated circuits described herein such as the integrated circuit of Figure 1, for example. Similarly labeled elements may be as previously described. Unless the context indicates otherwise, elements that maintain a same reference numeral throughout the drawings can be considered to share a same description which may be omitted to be repeated for the sake of brevity.

Referring to Figure 2, an integrated circuit 200 includes a circuit under test 210 that includes a FIFO circuit. It should be noted that here and in the following a convention has been adopted for brevity and clarity wherein elements adhering to the pattern [x10] where 'x' is the figure number may be related implementations of a circuit under test in various embodiments. For example, the circuit under test 210 may be similar to the circuit under test 110 except as otherwise stated. An analogous convention has also been adopted for other elements as made clear by the use of similar terms in conjunction with the aforementioned numbering system.

In this specific example, the circuit under test 210 includes a FIFO circuit and includes a first scan chain 221 selected as a first category (initiator logic) in the circuit under test 210 that is configured to write to the FIFO circuit (and read from the FIFO), and a second scan chain 222 selected as a second category (target logic) in the circuit under test 210 that includes a shift register (i.e. functional logic) of the FIFO circuit. In particular, a first set of scan flip flops 211 is coupled to the first scan enable signal 31 and a second set of scan flip flops 212 is coupled to the second scan enable signal 32 (shown here as the first scan chain 221 and the second scan chain 222 but may also include additional scan flip flops as part of the same scan chain or a different scan chain).

Here, SE_A (the first scan enable signal 31) can be made high during launch so that the launch is through the SI input of the first scan chain 221 (similar to LOS). There is no control limitation as with conventional LOC because the upstream scan flip flops are coupled to SE_A, which remains '1'. That is, the values of the test pattern are directly driven as they are in shift.

On the other hand, SE_B (the second scan enable signal 32) is made low during capture, but is not subject to the timing restrictions of conventional LOS because a delay (e.g., one or more empty test cycles) may be included between the last shift and the launch pulse. So, the functional outputs (Q output) of the second scan chain 222 are captured during the capture pulse. SE_B does not need to be high during launch to launch through the SI inputs because the launch is from the first scan chain 221 coupled to SE_A.

The first scan enable signal 31 and the second scan enable signal 32 may be driven from a controller. Controller scan flip flops may be part of yet another scan chain. Logic elements 226 of the FIFO circuit are tested using the first scan chain 221 and the second scan chain 222. For example, as shown here, the logic elements 226 may include combinational logic. Scan flip flops in the first scan chain 221 are located upstream of the logic elements 226 while scan flip flops of the second scan chain 222 are located downstream of the logic elements 226.

Figure3 illustrates an example integrated circuit with DFT functionality including a controller having a scan enable input that controls a first scan enable signal coupled to a first set of scan flip flops and also controls a second scan enable signal coupled to a second set of scan flip flops in accordance with embodiments of the invention. The integrated circuit of Figure 3 may be a specific implementation of other integrated circuits described herein such as the integrated circuit of Figure 1, for example. Similarly labeled elements may be as previously described.

Referring to Figure3, an integrated circuit 300 includes a circuit under test 310 including a first set of scan flip flops 311 coupled to a first scan enable signal 31 (SE_A), and a second set of scan flip flops 312 coupled to a second scan enable signal 32 (SE_B). The integrated circuit 300 also includes a controller 330 that is configured to simultaneously drive both SE_A and SE_B using a combined test pin 41. It should be noted that the combined test pin 41 may be an external connection (such as a test pad), but may also be an internal connection (such as an LBIST circuit). The use of the combined test pin 41 may be advantageous in applications with pin limitations, for example. In contrast to embodiments using separate pins, both the first scan enable signal 31 and the second scan enable signal 32 can be controlled using the combined test pin 41 by reading from internal scan flip flops. The controller 330 includes a scan enable input 35 that is coupled to the combined test pin 41. The first scan enable signal 31 is coupled to an output 77 of a first scan enable multiplexer 37 while the second scan enable signal 32 is coupled to an output 79 of a second scan enable multiplexer 39. The first scan enable multiplexer 37 and the second scan enable multiplexer 39 are used to select between outputs of internal scan flip flop(s) or the scan enable input 35, which is coupled to both a first input 57 of the first scan enable multiplexer 37 and the a first input 59 of the second scan enable multiplexer 39. Selection of the first scan enable multiplexer 37 and the second scan enable multiplexer 39 may be controlled using a test control unit (TCU) bit (tcu_bit_ 0).

The scan enable input 35 is also coupled to a first input 56 of a first OR gate 36 and a first input 58 of a second OR gate 38. Intermediate scan enable signals (SE_A_int and SE_B_int) are generated by the OR gates at output 76 and output 78, respectively. Additional inputs (a second input 66 and a second input 68) of the OR gates are connected to internal scan flip flops to provide control to the controller 330.

For example, as shown here, the output (Q) of a first controller scan flip flop 33 may be coupled to the second input 66 of the first OR gate 36 and the output (Q) of a second controller scan flip flop 34 may be coupled to second input 68 of the second OR gate 38. The outputs of the first controller scan flip flop 33 and the second controller scan flip flop 34 may be coupled to their respective functional inputs (D). The first controller scan flip flop 33 and the second controller scan flip flop 34 may be part of internal scan chains. Alternatively, (as discussed in reference to FIG. 4) a single controller scan flip flop can also be used instead of the two shown here.

When the scan enable input 35 is '1', both the first scan enable signal 31 and the second scan enable signal 32 are '1' due to the OR logic of the first OR gate 36 and the second OR gate 38. However, when the scan enable input 35 is '0', all four options ('00', '01', '10', '11') are possible. In this way, the controller 330 can be configured to simultaneously drive the first scan enable signal 31 and second scan enable signal 32 to test logic elements by controlling the transition between, for example asserting both the first scan enable signal 31 and the second scan enable signal 32 during shift and deasserting only one (or even both) during launch and/or capture. This allows the previously discussed launch and capture timing, as well as other timings which may be apparent to those of skill in the art.

FIG. 4 illustrates another example integrated circuit with DFT functionality including a controller having a scan enable input that controls a first scan enable signal coupled to a first set of scan flip flops and also controls a second scan enable signal coupled to a second set of scan flip flops in accordance with embodiments of the invention. The integrated circuit of FIG. 4 may be a specific implementation of other integrated circuits described herein such as the integrated circuit of FIG. 1, for example. Similarly labeled elements may be as previously described.

Referring to FIG. 4, an integrated circuit 400 includes a circuit under test 410 including a first set of scan flip flops 411 and a second set of scan flip flops 412 similar to the integrated circuit 300. Also similar to integrated circuit 300, the integrated circuit 400 includes a controller 430 with a scan enable input 35 that is coupled to the combined test pin 41 and at outputs delivering at least two scan enable signals (here, the first scan enable signal 31 and the second scan enable signal 32) to sets of scan flip flops. However, in contrast to the controller 330, the controller 430 includes a combined controller scan flip flop 43 with an output (Q) coupled to both the second input 66 of the first OR gate 36 and to an inverter 42 that is coupled to the second input 68 of the second OR gate 38.

The controller 430 is functionally similar to the controller 330 implementation. For example, when the scan enable input 35 is '1', both the first scan enable signal 31 and the second scan enable signal 32 are still '1' due to the OR logic of the first OR gate 36 and the second OR gate 38. But, different from the controller 430, when the scan enable input 35 is '0', only two options ('01', '10') are possible because of the inverter 42. This may be considered a minor different since the '11' state is still available with the scan enable input 35 is '1'. At any rate, the controller 430 can also be configured to simultaneously drive the first scan enable signal 31 and second scan enable signal 32 to test logic elements by controlling the transition between, for example asserting both the first scan enable signal 31 and the second scan enable signal 32 during shift and deasserting one of the two during launch and/or capture.

In comparison to the two scan flip flop implementation of the controller 330, the combined scan flip flop implementation of controller 430 may have a slightly higher pattern count while still maintaining a lower pattern count advantage over conventional methods.

The controller implementations of FIGS. 3 and 4 may be useful for low pin count applications. The connections between the scan flip flops in each set have been intentionally omitted because the controller 330 and the controller 430 may be used to control the first scan enable signal 31 and the second scan enable signal 32 regardless of the specific method of grouping scan flip flops in the circuit under test (e.g., considering design in an initiator/target configuration, without considering design according to a scripted rule, or some combination thereof).

In the foregoing examples, separate scan enable signals may be connected to sets (e.g., scan chains) of scan flip flops based on role/situation/location within the design. However, the possibility of connecting separate scan enable signals to sets of flip flops without regard for the specifics of the design was also mentioned. FIGS. 5-7 show several examples of how separate scan enable signals may be connected to sets of scan flip flops without considering design details for some or all of the scan flip flops in a design. That is, these implementations advantageously do not require knowledge of initiator logic or target logic in a given design.

FIG. 5 illustrates an example integrated circuit with DFT functionality including a first set of scan flip flops coupled to a first scan enable signal and a second set of scan flip flops coupled to a second scan enable signal in accordance with embodiments of the invention. The integrated circuit of FIG. 5 may be a specific implementation of other integrated circuits described herein such as the integrated circuit of FIG. 1, for example. Similarly labeled elements may be as previously described.

Referring to FIG. 5, an integrated circuit 500 includes a circuit under test 510, a first set of scan flip flops 511 and a second set of scan flip flops 512. Optionally, a controller 530 may be included in the integrated circuit 500 to drive the first scan enable signal 31 and the second scan enable signal 32 to test logic elements 526 of the circuit under test 510. Alternatively, test control may be entirely external. Similar to the integrated circuit 100 of FIG. 1, the first set of scan flip flops 511 are each coupled to the first scan enable signal 31 while the second set of scan flip flops 512 are each coupled to the second scan enable signal 32. However, unlike the integrated circuit 100, a first scan chain 521 includes scan flip flops from each set (e.g., the first scan chain 521 is a "mixed" scan chain).

While the first scan chain 521 could include all of the scan flip flops of both the first set of scan flip flops 511 and the second set of scan flip flops 512, it may also include a subset of each (as shown) reflecting the common occurrence that multiple scan chains are inserted. For example, a second scan chain 522 may include the some or all or the remaining scan flip flops of the first set of scan flip flops 511 and some or all of the remaining scan flip flops of the second set of scan flip flops 512, and so on.

One method of inserting scan chains in this manner, may be to insert scan chains with a single scan enable signal without considering the specifics of the design. Then, a script may be used to remove scan enable connections to some subset of the scan flip flops of the inserted scan chains according to some rule or rules and replace the connections with one or more additional scan enable signals. For example, adjacent scan flip flops throughout the design may be coupled to different scan enable signals (e.g., alternating between the first scan enable signal 31 and the second scan enable signal 32, as shown).

This allows the tool to use LOS launch with LOC capture when possible and to revert to conventional LOC otherwise (i.e. a mixture). LOS launch with LOC capture is exemplified in Figure 1. In this way the timing requirements of conventional LOS are still advantageously avoided, while the pattern count is still reduced over purely conventional LOC because of the ability to use LOS launch with LOC capture some of the time. Since this method of connecting separate scan enable signals does not require any knowledge of the design, it may be beneficial for use in delivery devices and production cuts, for example.

FIG. 6 illustrates another example integrated circuit with DFT functionality including a first set of scan flip flops coupled to a first scan enable signal and a second set of scan flip flops coupled to a second scan enable signal where the integrated circuit includes a FIFO circuit in accordance with embodiments of the invention. The integrated circuit of FIG. 6 may be a specific implementation of other integrated circuits described herein such as the integrated circuit of FIG. 5, for example. Similarly labeled elements may be as previously described.

Referring to FIG. 6, an integrated circuit 600 includes a circuit under test 610 that includes a FIFO circuit with logic elements 626. Like the circuit under test 210 that also includes a FIFO circuit, the circuit under test 610 includes first scan chain 621 configured to write to the FIFO circuit (and read from the FIFO) and a second scan chain 622 that includes a shift register of the FIFO circuit.

However, unlike the circuit under test 210, the first scan enable signal 31 and the second scan enable signal 32 were connected to a first set of scan flip flops 611 and a second set of scan flip flops 612, respectively, with no knowledge of the underlying design. In this specific example, adjacent scan flip flops were coupled to different scan enable signals (e.g., alternating between the first scan enable signal 31 and the second scan enable signal 32, as shown).

FIG. 7 illustrates an example scan flip flop of an integrated circuit with DFT functionality where the scan flip flop has a localized scan enable in accordance with embodiments of the invention. The integrated circuit of FIG. 7 may be a specific implementation of other scan flip flops described herein and may be included in the integrated circuits described herein such as the integrated circuit of FIG. 1, for example. Similarly labeled elements may be as previously described.

Referring to FIG. 7, a scan flip flop 713 may be used in any of the sets of scan flip flops or scan chains included in the circuits under test of the integrated circuit described herein. As shown, a localized scan enable has been configured for the scan flip flop 713 using an OR gate 71 coupled to a test pin 74 (e.g. through scripts without considering the design). The localized scan enable may also avoid the stringent timing requirements of the scan enable path of conventional LOS by enabling a local LOS launching paradigm.

FIG. 8 illustrates an example method of testing an integrated circuit with DFT functionality including a first set of scan flip flops coupled to a first scan enable signal and a second set of scan flip flops coupled to a second scan enable signal in accordance with embodiments of the invention. The method of FIG. 8 may be combined with other methods and performed using the systems and apparatuses as described herein. For example, the method of FIG. 8 may be combined with any of the embodiments of FIGS. 1-7. Although shown in a logical order, the arrangement and numbering of the steps of FIG. 8 are not intended to be limited. The method steps of FIG. 8 may be performed in any suitable order or concurrently with one another as may be apparent to a person of skill in the art.

Referring to Figure 8, a step 801 of a method 800 of testing an integrated circuit includes shifting a first test pattern into a first set of scan flip flops of the integrated circuit. The first set of scan flip flops are upstream of first logic elements of the integrated circuit. The shifting of the first test pattern is performed while asserting both a first scan enable signal and a second scan enable signal. Each of the scan flip flops of the first set include a scan enable input coupled to the first scan enable signal. As exemplified in Figure 8, block 801 illustrates and operation of shifting a first test pattern into a first set of scan flip flops of an integrated circuit upstream of first logic elements of the integrated circuit while asserting both a first scan enable signal and a second scan enable signal, each of the scan flip flops of the first set comprising a scan enable input coupled to the first scan enable signal

In step 802, the second scan enable signal is deasserted while continuing to assert the first scan enable signal. As exemplified in Figure 8, block 802 illustrates and operation of deasserting the second scan enable signal while continuing to assert the first scan enable signal.

As exemplified in Figure 8, block 803 illustrates an operation of launching the first test pattern. The first test pattern is launched in step 803.

Then, in step 804, results are captured from a second set of scan flip flops of the integrated circuit. The second set of scan flip flops are downstream of the first logic elements. In contrast to the first set of scan flip flops which are coupled to the first scan enable signal, each of the scan flip flops of the second set include a scan enable input coupled to the second scan enable signal. The capturing of the results is performed while the first scan enable signal is asserted and the second scan enable signal is deasserted. As exemplified in Figure 8, block 804 illustrates an operation of capturing results from a second set of scan flip flops of the integrated circuit downstream of the first logic elements while the first scan enable signal is asserted and the second scan enable signal is deasserted, each of the scan flip flops of the second set comprising a scan enable input coupled to the second scan enable signal. Example embodiments of the invention are summarized here. Other embodiments can also be understood from the entirety of the specification as well as the claims filed herein. The solution as described herein is set out in the appended set of claims.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. An integrated circuit (100, 200, 300, 400, 500, 600) comprising:
a first set of scan flip flops (111, 211, 311, 411, 511, 611), each of the scan flip flops of the first set of scan flip flops (111, 211, 311, 411, 511, 611) comprising a scan enable input (16, SE) coupled to a first scan enable signal (31);
a circuit under test (110, 210, 310, 410, 510, 610) comprising logic elements (126, 226, 526, 626) downstream of the first set of scan flip flops (111, 211, 311, 411, 511, 611);
a second set of scan flip flops (112, 212, 312, 412, 512, 612) comprising at least one scan flip flop downstream of the logic elements (126, 226, 526, 626), each of the scan flip flops of the second set of scan flip flops (112, 212, 312, 412, 512, 612) comprising a scan enable input (16, SE) coupled to a second scan enable signal (32); and
a controller (130, 330, 430, 530) configured to test the logic elements (126, 226, 526, 626) as a result of:
shifting test patterns (801) into the first set of scan flip flops (111; 511) while asserting both the first scan enable signal (31) and the second scan enable signal (32),
launching the test patterns (803), and
capturing (802, 804) results from the second set of scan flip flops (112; 512) while deasserting the second scan enable signal (32) and continuing to assert the first scan enable signal (31).

2. The integrated circuit (100, 200, 300, 400, 500, 600) of claim 1, wherein the first set of scan flip flops (111, 211, 311, 411, 511, 611) is a first scan chain (121, 221, 521, 621), and wherein the second set of scan flip flops (112, 212, 312, 412, 512, 612) is a second scan chain (122, 222, 522, 622) that is separate from the first scan chain (121, 221, 521, 621).

3. The integrated circuit (100, 200, 300, 400, 500, 600) of claim 1, wherein the circuit under test (110, 210, 310, 410, 510, 610) comprises a first in, first out - FIFO circuit, wherein the scan flip flops of the first scan chain of scan flip flops (121, 221, 521, 621) are configured to write to the FIFO circuit, and wherein the scan flip flops of the second scan chain (122, 222, 522, 622) comprise a shift register of the FIFO circuit.

4. The integrated circuit (100, 200, 300, 400, 500, 600) of claim 1, further comprising:
a scan chain of scan flip flops (521, 621; 522, 622) comprising a subset of the first set of scan flip flops (111, 211, 311, 511, 611) and a subset of the second set of scan flip flops (122, 322, 522, 622), wherein the scan enable inputs (SE) of adjacent scan flip flops of the scan chain of flip flops (521, 621; 522, 622) are coupled to different scan enable signals (SE_A, SE_B),
preferably wherein the integrated circuit (100; 500) further comprises a first test pin (14) coupled to the first scan enable signal (31), and a second test pin (15) coupled to the second scan enable signal (32).

5. The integrated circuit (100; 500) of claim 1, wherein the controller (130; 330; 430; 530) is configured to simultaneously drive the first scan enable signal (31) and the second scan enable signal (32) to test the logic elements (126; 526), the controller (130; 330; 430; 530) comprising
a scan enable input (35),
at least one controller scan flip flop (33, 34, 43),
a first OR gate (36) comprising a first input (56) coupled to the scan enable input (35), and a second input (66) coupled to the at least one controller scan flip flop (33, 34, 43),
a first scan enable multiplexer (37) comprising a first input (57) coupled to the scan enable input (35), a second input (67) coupled to the first OR gate (36), and an output (77) coupled to the first scan enable signal (31),
a second OR gate (38) comprising a first input (58) coupled to the scan enable input (35), and a second input (68) coupled to the at least one controller scan flip flop (33, 34, 43), and
a second scan enable multiplexer (39) comprising a first input (59) coupled to the scan enable input (35), a second input (69) coupled to the second OR gate (38), and an output (79) coupled to the second scan enable signal (32), preferably wherein the at least one controller scan flip flop (33, 34, 43):
- comprises a first controller scan flip flop (33) coupled to the second input of the first OR gate (36), and a second controller scan flip flop (34) coupled to the second input of the second OR gate, and/or
- is a combined controller scan flip flop (43) comprising an output coupled to both the second input of the first OR gate (36) and to an inverter coupled to the second input of the second OR gate, and/or
- further comprises a combined test pin (41) coupled to the scan enable input (35) of the controller (130, 330, 430, 530), and/or
- further comprises a logic built-in self-test circuit coupled to the scan enable input (35) of the controller (130, 330, 430, 530).

6. The integrated circuit (100, 200, 300, 400, 500, 600) according to claim 1, wherein:
the circuit under test (110, 210, 310, 410, 510, 610) comprises initiator logic elements and target logic elements;
a first scan chain (121, 221, 521, 621) of scan flip flops comprises the initiator logic elements, each scan flip flop of the first scan chain (121, 221, 521, 621) comprising the scan enable input (16) coupled to the first scan enable signal (31);
a second scan chain (122, 222, 522, 622) of scan flip flops comprises the target logic elements, each of the scan flip flops of the second scan chain (122, 222, 522, 622) comprising the scan enable input (16) coupled to the second scan enable signal (32); and
the controller (130, 330, 430, 530) is configured to test the circuit under test (110, 210, 310, 410, 510, 610) by:
shifting a first test pattern into the first scan chain (121, 221, 521, 621) while both the initiator logic elements and the target logic elements are operating in launch mode,
launching the first test pattern, and
capturing results from the second scan chain (122, 222, 522, 622) while the initiator logic elements are operating in launch mode and the target logic elements are operating in capture mode.

7. The integrated circuit (100, 200, 300, 400, 500, 600) of claim 6, wherein the circuit under test (110, 210, 310, 410, 510, 610) comprises a first in, first out - FIFO circuit, wherein the initiator logic elements are configured to write to the FIFO circuit, and wherein the target logic elements comprise a shift register of the FIFO circuit.

8. The integrated circuit (100, 200, 300, 400, 500, 600) of claim 6, wherein the circuit under test (110, 210, 310, 410, 510, 610) comprises a Joint Test Action Group - JTAG, state machine, wherein the initiator logic elements comprise a common shift data register, and wherein the target logic elements comprise multiple test data registers.

9. The integrated circuit (100, 200, 300, 400, 500, 600) of claim 6, wherein the controller (130, 330, 430, 530) is further configured to test the circuit under test (110, 210, 310, 410, 510, 610) as a result of:
shifting a second test pattern into the second scan chain (122, 222, 522, 622) while both the initiator logic elements and the target logic elements are operating in launch mode,
launching the second test pattern, and
capturing results from the first scan chain (121, 221, 521, 621) while the initiator logic elements are operating in capture mode and the target logic elements are operating in launch mode.

10. The integrated circuit (100, 200, 300, 400, 500, 600) of claim 9, wherein:
- the circuit under test (110, 210, 310, 410, 510, 610) comprises a memory circuit,
- the target logic elements comprise memory cells of the memory circuit, and
- the initiator logic elements are configured to write to the memory cells during testing using the first test pattern and configured to read from the memory cells during testing using the second test pattern.

11. A method of testing an integrated circuit (100, 200, 300, 400, 500, 600), the method comprising:
shifting a first test pattern into a first set of scan flip flops (111, 211, 311, 411, 511, 611) of the integrated circuit (100, 200, 300, 400, 500, 600) upstream of first logic elements (126, 226, 526, 626) of the integrated circuit (100, 200, 300, 400, 500, 600) while asserting both a first scan enable signal (31) and a second scan enable signal (32), each of the scan flip flops of the first set comprising a scan enable input (16) coupled to the first scan enable signal (31);
deasserting the second scan enable signal (32) while continuing to assert the first scan enable signal (31);
launching the first test pattern; and
capturing results from a second set of scan flip flops (112, 212, 312, 412, 512, 612) of the integrated circuit (100, 200, 300, 400, 500, 600) downstream of the first logic elements (126, 226, 526, 626) while the first scan enable signal (31) is asserted and the second scan enable signal (32) is deasserted, each of the scan flip flops of the second set comprising a scan enable input (16) coupled to the second scan enable signal (32).

12. The method of claim 11, wherein the first set of scan flip flops (111, 211, 311, 411, 511, 611) is a first scan chain (121, 221, 521, 621), and wherein the second set of scan flip flops (112, 212, 312, 412, 512, 612) is a second scan chain (122, 222, 522, 622) that is separate from the first scan chain (121, 221, 521, 621).

13. The method of claim 12, wherein the integrated circuit (100, 200, 300, 400, 500, 600) comprises a first in, first out, FIFO, circuit, wherein the scan flip flops of the first scan chain (121, 221, 521, 621) are configured to write to the FIFO circuit, and wherein the scan flip flops of the second scan chain (122, 222, 522, 622) comprise a shift register of the FIFO circuit.

14. The method of claim 12, wherein the integrated circuit (100, 200, 300, 400, 500, 600) comprises a scan chain of scan flip flops (521, 621, 522, 622) comprising a subset of the first set and a subset of the second set, wherein the scan enable inputs of adjacent scan flip flops of the scan chain are coupled to different scan enable signals.

15. The method of claim 12, further comprising:
shifting a second test pattern into the second set of scan flip flops (112, 212, 312, 412, 512, 612) while asserting both the first scan enable signal (31) and the second scan enable signal (32), the second set of scan flip flops (112, 212, 312, 412, 512, 612) being upstream of second logic elements (126, 226, 526, 626) of the integrated circuit (100, 200, 300, 400, 500, 600);
deasserting the first scan enable signal (31) while continuing to assert the second scan enable signal (32);
launching the second test pattern and capturing results from the first set of scan flip flops (111, 211, 311, 411, 511, 611) while the first scan enable signal (31) is deasserted and the second scan enable signal (32) is asserted, the first set of scan flip flops (111, 211, 311, 411, 511, 611) being downstream of the second logic elements (126, 226, 526, 626).

## Patentansprüche

1. Integrierte Schaltung (100, 200, 300, 400, 500, 600), umfassend:
einen ersten Satz von Scan-Flipflops (111, 211, 311, 411, 511, 611), wobei jedes der Scan-Flipflops des ersten Satzes von Scan-Flipflops (111, 211, 311, 411, 511, 611) einen Scan-Freigabeeingang (16, SE) umfasst, der mit einem ersten Scan-Freigabesignal (31) gekoppelt ist;
eine zu prüfende Schaltung (110, 210, 310, 410, 510, 610), umfassend Logikelemente (126, 226, 526, 626) stromabwärts des ersten Satzes von Scan-Flipflops (111, 211, 311, 411, 511, 611);
einen zweiten Satz Scan-Flipflops (112, 212, 312, 412, 512, 612) umfassend mindestens ein Scan-Flipflop stromabwärts der Logikelemente (126, 226, 526, 626), jedes der Scan-Flipflops des zweiten Satzes Scan-Flipflops (112, 212, 312, 412, 512, 612) umfassend einen Scan-Freigabeeingang (16, SE), der mit einem zweiten Scan-Freigabesignal (32) gekoppelt ist; und
eine Steuereinheit (130, 330, 430, 530), die konfiguriert ist, um die Logikelemente (126, 226, 526, 626) zu prüfen, als Ergebnis von:
Verschieben von Prüfmustern (801) in den ersten Satz von Scan-Flipflops (111; 511) bei Behaupten von beiden, des ersten Scan-Freigabesignals (31) und des zweiten Scan-Freigabesignals (32),
Starten der Prüfmuster (803), und
Erfassen (802, 804) von Ergebnissen aus dem zweiten Satz von Scan-Flipflops (112; 512), bei Deaktivieren des zweiten Scan-Freigabesignals (32) und weiterem Behaupten des ersten Scan-Freigabesignals (31).

2. Integrierte Schaltung (100, 200, 300, 400, 500, 600) nach Anspruch 1, wobei der erste Satz von Scan-Flipflops (111, 211, 311, 411, 511, 611) eine erste Scan-Kette (121, 221, 521, 621) ist, und wobei der zweite Satz von Scan-Flipflops (112, 212, 312, 412, 512, 612) eine zweite Scan-Kette (122, 222, 522, 622) ist, die von der ersten Scan-Kette (121, 221, 521, 621) getrennt ist.

3. Integrierte Schaltung (100, 200, 300, 400, 500, 600) nach Anspruch 1, wobei die zu prüfende Schaltung (110, 210, 310, 410, 510, 610) umfasst eine first in, first out-FIFO-Schaltung umfasst, wobei die Scan-Flipflops der ersten Scan-Kette von Scan-Flipflops (121, 221, 521, 621) konfiguriert sind, auf die FIFO-Schaltung zu schreiben, wobei die Scan-Flipflops der zweiten Scan-Kette (122, 222, 522, 622) ein Verschieberegister der FIFO-Schaltung umfassen.

4. Integrierte Schaltung (100, 200, 300, 400, 500, 600) nach Anspruch 1, weiter umfassend:
eine Scan-Kette von Scan-Flipflops (521, 621; 522, 622), umfassend eine Teilmenge des ersten Satzes von Scan-Flipflops (111, 211, 311, 511, 611) und eine Teilmenge des zweiten Satzes von Scan-Flipflops (122, 322, 522, 622), wobei die Scan-Freigabeeingänge (SE) benachbarter Scan-Flipflops der Scan-Kette von Flipflops (521, 621; 522), 622) mit verschiedenen Scan-Freigabesignalen (SE_A, SE_B) gekoppelt sind,
wobei die integrierte Schaltung (100; 500) vorzugsweise weiter einen ersten Prüfstift (14) umfasst, der mit dem ersten Scan-Freigabesignal (31) gekoppelt ist, und einen zweiten Prüfstift (15), der mit dem zweiten Scan-Freigabesignal (32) gekoppelt ist.

5. Integrierte Schaltung (100; 500) nach Anspruch 1, wobei die Steuereinheit (130; 330; 430; 530) konfiguriert ist, um gleichzeitig das erste Scan-Freigabesignal (31) und das zweite Scan-Freigabesignal (32) anzusteuern, um die Logikelemente (126; 526) zu prüfen, wobei die Steuereinheit (130; 330; 430; 530) umfasst einen Scan-Freigabeeingang (35),
mindestens ein Steuereinheiten-Scan-Flipflop (33, 34, 43), ein erstes ODER-Gate (36) umfassend einen ersten Eingang (56), der mit dem Scan-Freigabeeingang (35) gekoppelt ist, und einen zweiten Eingang (66), der mit dem mindestens einen Steuereinheiten-Scan-Flipflop (33, 34, 43) gekoppelt ist,
einen ersten Scan-Freigabe-Multiplexer (37), der einen ersten Eingang (57) umfasst, der mit dem Scan-Freigabeeingang (35) gekoppelt ist, einen zweiten Eingang (67), der mit dem ersten ODER-Gate (36) gekoppelt ist, und einen Ausgang (77), der mit dem ersten Scan-Freigabesignal (31) gekoppelt ist,
ein zweites ODER-Gate (38), das einen ersten Eingang (58) umfasst, der mit dem Scan-Freigabeeingang (35) gekoppelt ist, und einen zweiten Eingang (68), der mit dem mindestens einen Steuereinheiten-Scan-Flipflop (33, 34, 43) gekoppelt ist, und
einen zweiten Scan-Freigabe-Multiplexer (39), der einen ersten Eingang (59) umfasst, der mit dem Scan-Freigabeeingang (35) gekoppelt ist, einen zweiten Eingang (69), der mit dem zweiten ODER-Gate (38) gekoppelt ist, und einen Ausgang (79), der mit dem zweiten Scan-Freigabesignal (32) gekoppelt ist, wobei vorzugsweise das mindestens eine Steuereinheiten-Scan-Flipflop (33, 34, 43):
- ein erstes Steuereinheiten-Scan-Flipflop (33) umfasst, das mit dem zweiten Eingang des ersten ODER-Gates (36) gekoppelt ist, und ein zweites Steuereinheiten-Scan-Flipflop (34), das mit dem zweiten Eingang des zweiten ODER-Gates gekoppelt ist, und/oder
- ein kombiniertes Steuereinheiten-Scan-Flipflop (43) ist, das einen Ausgang umfasst, der mit beiden, dem zweiten Eingang des ersten ODER-Gates (36) und einem mit dem zweiten Eingang des zweiten ODER-Gates gekoppelten Wechselrichter gekoppelt ist, und/oder
- weiter einen kombinierten Prüfstift (41) umfasst, der mit dem Scan-Freigabeeingang (35) der Steuereinheit (130, 330, 430, 530) gekoppelt ist, und/oder
- weiter eine eingebaute logische Selbstprüfschaltung umfasst, die mit dem Scan-Freigabeeingang (35) der Steuereinheit (130, 330, 430, 530) gekoppelt ist.

6. Integrierte Schaltung (100, 200, 300, 400, 500, 600) nach Anspruch 1, wobei:
die zu prüfende Schaltung (110, 210, 310, 410, 510, 610) Initiator-Logikelemente und Ziel-Logikelemente umfasst;
eine erste Scan-Kette (121, 221, 521, 621) von Scan-Flipflops die Initiator-Logikelemente umfasst, wobei jedes Scan-Flipflop der ersten Scan-Kette (121, 221, 521, 621) den Scan-Freigabeeingang (16) umfasst, der mit dem ersten Scan-Freigabesignal (31) gekoppelt ist;
eine zweite Scan-Kette (122, 222, 522, 622) von Scan-Flipflops die Ziel-Logikelemente umfasst, wobei jedes der Scan-Flipflops der zweiten Scan-Kette (122, 222, 522, 622) den Scan-Freigabeeingang (16) umfasst, der mit dem zweiten Scan-Freigabesignal (32) gekoppelt ist; und
die Steuereinheit (130, 330, 430, 530) konfiguriert ist, um die zu prüfende Schaltung (110, 210, 310, 410, 510, 610) zu prüfen durch:
Verschieben eines ersten Prüfmusters in die erste Scan-Kette (121, 221, 521, 621), während beide, die Initiator-Logikelemente und die Ziel-Logikelemente in dem Start-Modus arbeiten,
Starten des ersten Prüfmusters und
Erfassen von Ergebnissen aus der zweiten Scan-Kette (122, 222, 522, 622), während die Initiator-Logikelemente in dem Start-Modus arbeiten und die Ziel-Logikelemente in dem Erfassungsmodus arbeiten.

7. Integrierte Schaltung (100, 200, 300, 400, 500, 600) nach Anspruch 6, wobei die zu prüfende Schaltung (110, 210, 310, 410, 510, 610) eine First in, First Out-FIFO-Schaltung umfasst, wobei die Initiator-Logikelemente konfiguriert sind, um in die FIFO-Schaltung zu schreiben, und wobei die Ziel-Logikelemente ein Verschieberegister der FIFO-Schaltung umfassen.

8. Integrierte Schaltung (100, 200, 300, 400, 500, 600) nach Anspruch 6, wobei die zu prüfende Schaltung (110, 210, 310, 410, 510, 610) eine Joint Test Action Group-, JTAG-Zustandsmaschine umfasst, wobei die Initiator-Logikelemente ein gemeinsames Schiebedatenregister umfassen, und wobei die Ziel-Logikelemente mehrere Prüfdatenregister umfassen.

9. Integrierte Schaltung (100, 200, 300, 400, 500, 600) nach Anspruch 6, wobei die Steuereinheit (130, 330, 430, 530) weiter konfiguriert ist, um die zu prüfende Schaltung (110, 210, 310, 410, 510, 610) als Ergebnis zu prüfen von:
Verschieben eines zweiten Prüfmusters in die zweite Scan-Kette (122, 222, 522, 622), während beide, die Initiator-Logikelemente und die Ziel-Logikelemente in dem Start-Modus arbeiten,
Starten des zweiten Prüfmusters, und
Erfassen von Ergebnissen aus der ersten Scan-Kette (121, 221, 521, 621), während die Initiator-Logikelemente in dem Erfassungsmodus arbeiten und die Ziel-Logikelemente in dem Startmodus arbeiten.

10. Integrierte Schaltung (100, 200, 300, 400, 500, 600) nach Anspruch 9, wobei:
- die zu prüfende Schaltung (110, 210, 310, 410, 510, 610) eine Speicherschaltung umfasst,
- die Ziel-Logikelemente Speicherzellen der Speicherschaltung umfassen, und
- die Initiator-Logikelemente konfiguriert sind, um während des Prüfens unter Verwendung des ersten Prüfmusters in die Speicherzellen schreiben und konfiguriert sind, um unter Verwendung des zweiten Prüfmusters aus den Speicherzellen auszulesen.

11. Verfahren zum Prüfen einer integrierten Schaltung (100, 200, 300, 400, 500, 600), wobei das Verfahren umfasst:
Verschieben eines ersten Prüfmusters in einen ersten Satz von Scan-Flipflops (111, 211, 311, 411, 511, 611) der integrierten Schaltung (100, 200, 300, 400, 500, 600) stromaufwärts der ersten Logikelemente (126, 226, 526, 626) der integrierten Schaltung (100, 200, 300, 400, 500, 600) bei Behaupten von beiden, eines ersten Scan-Freigabesignals (31) und eines zweiten Scan-Freigabesignals (32), wobei jedes der Scan-Flipflops des ersten Satzes einen mit dem ersten Scan-Freigabesignal (31) gekoppelten Scan-Freigabeeingang (16) umfasst;
Deaktivieren des zweiten Scan-Freigabesignals (32) bei weiterem Behaupten des ersten Scan-Freigabesignals (31);
Starten des ersten Prüfmusters; und
Erfassen von Ergebnissen aus einem zweiten Satz von Scan-Flipflops (112, 212, 312, 412, 512, 612) der integrierten Schaltung (100, 200, 300, 400, 500, 600) stromabwärts der ersten Logikelemente (126, 226, 526, 626), bei Behaupten des ersten Scan-Freigabesignals (31) und Deaktivieren des zweiten Scan-Freigabesignals (32), wobei jedes der Scan-Flipflops des zweiten Satzes einen mit dem zweiten Scan-Freigabesignal (32) gekoppelten Scan-Freigabeeingang (16) umfasst.

12. Verfahren nach Anspruch 11, wobei der erste Satz von Scan-Flipflops (111, 211, 311, 411, 511, 611) eine erste Scan-Kette (121, 221, 521, 621) ist, und wobei der zweite Satz von Scan-Flipflops (112, 212, 312, 412, 512, 612) eine zweite Scan-Kette (122, 222, 522, 622) ist, die von der ersten Scan-Kette (121, 221, 521, 621) getrennt ist.

13. Verfahren nach Anspruch 12, wobei die integrierte Schaltung (100, 200, 300, 400, 500, 600) eine first in, first out-FIFO-Schaltung umfasst, wobei die Scan-Flipflops der ersten Scan-Kette von Scan-Flipflops (121, 221, 521, 621) konfiguriert sind, auf die FIFO-Schaltung zu schreiben, wobei die Scan-Flipflops der zweiten Scan-Kette (122, 222, 522, 622) ein Verschieberegister der FIFO-Schaltung umfassen.

14. Verfahren nach Anspruch 12, wobei die integrierte Schaltung (100, 200, 300, 400, 500, 600) eine Scan-Kette von Scan-Flipflops (521, 621, 522, 622) umfasst, die eine Teilmenge des ersten Satzes und eine Teilmenge des zweiten Satzes umfasst, wobei die Scan-Freigabeeingänge benachbarter Scan-Flipflops der Scan-Kette mit verschiedenen Scan-Freigabesignalen gekoppelt sind.

15. Verfahren nach Anspruch 12, weiter umfassend:
Verschieben eines zweiten Prüfmusters in den zweiten Satz von Scan-Flipflops (112, 212, 312, 412, 512, 612) bei Behaupten von beiden, des ersten Scan-Freigabesignals (31) und des zweiten Scan-Freigabesignals (32), wobei der zweite Satz von Scan-Flipflops (112, 212, 312, 412, 512, 612) stromaufwärts von zweiten Logikelementen (126, 226, 526, 626) der integrierten Schaltung (100, 200, 300, 400, 500, 600) liegt;
Deaktivieren des ersten Scan-Freigabesignals (31) bei weiterem Behaupten des zweiten Scan-Freigabesignals (32); Starten des zweiten Prüfmusters und Erfassen von Ergebnissen aus dem ersten Satz von Scan-Flipflops (111, 211, 311, 411, 511, 611) bei Deaktivieren des ersten Scan-Freigabesignals (31) und Behaupten des zweiten Scan-Freigabesignals (32), wobei der erste Satz von Scan-Flipflops (111, 211, 311, 411, 511, 611) stromabwärts der zweiten Logikelemente (126, 226, 526, 626) liegt.

## Revendications

1. Circuit intégré (100, 200, 300, 400, 500, 600) comprenant :
un premier ensemble de bascules de balayage (111, 211, 311, 411, 511, 611), chacune des bascules de balayage du premier ensemble de bascules de balayage (111, 211, 311, 411, 511, 611) comprenant une entrée d'activation de balayage (16, SE) couplée à un premier signal d'activation de balayage (31) ;
un circuit testé (110, 210, 310, 410, 510, 610) comprenant des éléments logiques (126, 226, 526, 626) en aval du premier ensemble de bascules de balayage (111, 211, 311, 411, 511, 611) ;
un second ensemble de bascules de balayage (112, 212, 312, 412, 512, 612) comprenant au moins une bascule de balayage en aval des éléments logiques (126, 226, 526, 626), chacune des bascules de balayage du second ensemble de bascules de balayage (112, 212, 312, 412, 512, 612) comprenant une entrée d'activation de balayage (16, SE) couplée à un second signal d'activation de balayage (32) ; et
une commande (130, 330, 430, 530) configurée pour tester les éléments logiques (126, 226, 526, 626) comme un résultat de :
décaler des motifs de test (801) dans le premier ensemble de bascules de balayage (111; 511) tout en activant à la fois le premier signal d'activation de balayage (31) et le second signal d'activation de balayage (32),
lancer les motifs de test (803), et
capturer (802, 804) des résultats depuis le second ensemble de bascules de balayage (112; 512) tout en désactivant le second signal d'activation de balayage (32) et en continuant d'activer le premier signal d'activation de balayage (31).

2. Circuit intégré (100, 200, 300, 400, 500, 600) selon la revendication 1, dans lequel le premier ensemble de bascules de balayage (111, 211, 311, 411, 511, 611) est une première chaîne de balayage (121, 221, 521, 621), et dans lequel le second ensemble de bascules de balayage (112, 212, 312, 412, 512, 612) est une seconde chaîne de balayage (122, 222, 522, 622) qui est séparée de la première chaîne de balayage (121, 221, 521, 621).

3. Circuit intégré (100, 200, 300, 400, 500, 600) selon la revendication 1, dans lequel le circuit testé (110, 210, 310, 410, 510, 610) comprend un circuit premier entré, premier sorti PEPS, dans lequel les bascules de balayage de la première chaîne de balayage des bascules de balayage (121, 221, 521, 621) sont configurées pour écrire dans le circuit PEPS, et dans lequel les bascules de balayage de la seconde chaîne de balayage (122, 222, 522, 622) comprennent un registre à décalage du circuit PEPS.

4. Circuit intégré (100, 200, 300, 400, 500, 600) selon la revendication 1, comprenant en outre :
une chaîne de balayage de bascules de balayage (521, 621; 522, 622) comprenant un sous-ensemble du premier ensemble de bascules de balayage (111, 211, 311, 511, 611) et un sous-ensemble du second ensemble de bascules de balayage (122, 322, 522, 622), dans lequel les entrées d'activation de balayage (SE) de bascules de balayage adjacentes de la chaîne de balayage de bascules (521, 621; 522, 622) sont couplées à différents signaux d'activation de balayage (SE_A, SE_B),
de préférence dans lequel le circuit intégré (100; 500) comprend en outre une première broche de test (14) couplée au premier signal d'activation de balayage (31), et une seconde broche de test (15) couplée au second signal d'activation de balayage (32).

5. Circuit intégré (100; 500) selon la revendication 1, dans lequel la commande (130, 330; 430, 530) est configurée pour commander simultanément le premier signal d'activation de balayage (31) et le second signal d'activation de balayage (32) pour tester les éléments logiques (126; 526) la commande (130, 330, 430, 530) comprenant,
une entrée d'activation de balayage (35),
au moins une bascule de balayage de commande (33, 34, 43),
une première porte OU (36) comprenant une première entrée (56) couplée à l'entrée d'activation de balayage (35), et une seconde entrée (66) couplée à l'au moins une bascule de balayage de commande (33, 34, 43),
un premier multiplexeur d'activation de balayage (37) comprenant une première entrée (57) couplée à l'entrée d'activation de balayage (35), une seconde entrée (67) couplée à la première porte OU (36), et une sortie (77) couplée au premier signal d'activation de balayage (31),
une seconde porte OU (38) comprenant une première entrée (58) couplée à l'entrée d'activation de balayage (35), et une seconde entrée (68) couplée à l'au moins une bascule de balayage de commande (33, 34, 43), et
un second multiplexeur d'activation de balayage (39) comprenant une première entrée (59) couplée à l'entrée d'activation de balayage (35), une seconde entrée (69) couplée à la seconde porte OU (38), et une sortie (79) couplée au second signal d'activation de balayage (32),
de préférence dans lequel l'au moins une bascule de balayage de commande (33, 34, 43) :
comprend une première bascule de balayage de commande (33) couplée à la seconde entrée de la première porte OU (36), et une seconde bascule de balayage de commande (34) couplée à la seconde entrée de la seconde porte OU, et/ou
est une bascule de balayage de commande combinée (43) comprenant une sortie couplée à la fois à la seconde entrée de la première porte OU (36) et à un inverseur couplé à la seconde entrée de la seconde porte OU, et/ou
comprend en outre une broche de test combinée (41) couplée à l'entrée d'activation de balayage (35) de la commande (130, 330, 430, 530), et/ou
comprend en outre un circuit auto-testant intégré logique couplé à l'entrée d'activation de balayage (35) de la commande (130, 330, 430, 530).

6. Circuit intégré (100, 200, 300, 400, 500, 600) selon la revendication 1, dans lequel :
le circuit testé (110, 210, 310, 410, 510, 610) comprend des éléments logiques de lancement et des éléments logiques cibles ;
une première chaîne de balayage (121, 221, 521, 621) de bascules de balayage comprend les éléments logiques de lancement, chaque bascule de balayage de la première chaîne de balayage (121, 221, 521, 621) comprenant l'entrée d'activation de balayage (16) couplée au premier signal d'activation de balayage (31) ;
une seconde chaîne de balayage (122, 222, 522, 622) de bascules de balayage comprend les éléments logiques cibles, chacune des bascules de balayage de la seconde chaîne de balayage (122, 222, 522, 622) comprenant l'entrée d'activation de balayage (16) couplée au second signal d'activation de balayage (32) ; et
la commande (130, 330, 430, 530) est configurée pour tester le circuit testé (110, 210, 310, 410, 510, 610) en :
décalant un premier motif de test dans la première chaîne de balayage (121, 221, 521, 621) alors qu'à la fois les éléments logiques initiateurs et les éléments logiques cibles fonctionnent en mode lancement,
lançant le premier motif de test, et
capturant des résultats venant de la seconde chaîne de balayage (122, 222, 522, 622) alors que les éléments logiques de lancement fonctionnent en mode lancement et les éléments logiques cibles fonctionnent en mode capture.

7. Circuit intégré (100, 200, 300, 400, 500, 600) selon la revendication 6, dans lequel le circuit testé (110, 210, 310, 410, 510, 610) comprend un circuit premier entré, premier sorti PEPS, dans lequel les éléments logiques de lancement sont configurés pour écrire dans le circuit PEPS, et dans lequel les éléments logiques cibles comprennent un registre à décalage du circuit PEPS.

8. Circuit intégré (100, 200, 300, 400, 500, 600) selon la revendication 6, dans lequel le circuit testé (110, 210, 310, 410, 510, 610) comprend une machine d'état Joint Test Action Group - JTAG, dans lequel les éléments logiques de lancement comprennent un registre de données à décalage commun, et dans lequel les éléments logiques cibles comprennent des registres de données de tests multiples.

9. Circuit intégré (100, 200, 300, 400, 500, 600) selon la revendication 6, dans lequel la commande (130, 330, 430, 530) est en outre configurée pour tester le circuit testé (110, 210, 310, 410, 510, 610) en résultat de :
décaler un second motif de test dans la seconde chaîne de balayage (122, 222, 522, 622) alors qu'à la fois les éléments logiques de lancement et les éléments logiques cibles fonctionnent en mode lancement,
lancer le second motif de test, et
capturer des résultats depuis la première chaîne de balayage (121, 221, 521, 621) alors que les éléments logiques de lancement fonctionnent en mode capture et les éléments logiques cibles fonctionnent en mode lancement.

10. Circuit intégré (100, 200, 300, 400, 500, 600) selon la revendication 9, dans lequel :
le circuit testé (110, 210, 310, 410, 510, 610) comprend un circuit de mémoire,
les éléments logiques cibles comprennent des cellules de mémoire du circuit de mémoire, et
les éléments logiques de lancement sont configurés pour écrire dans les cellules de mémoire pendant le test en utilisant le premier motif de test et configurés pour lire depuis les cellules de mémoire pendant le test en utilisant le second motif de test.

11. Procédé de test d'un circuit intégré (100, 200, 300, 400, 500, 600), le procédé comprenant :
de décaler un premier motif de test dans un premier ensemble de bascules de balayage (111, 211, 311, 411, 511, 611) du circuit intégré (100, 200, 300, 400, 500, 600) en amont des premiers éléments logiques (126, 226, 526, 626) du circuit intégré (100, 200, 300, 400, 500, 600) tout en activant à la fois un premier signal d'activation de balayage (31) et un second signal d'activation de balayage (32), chacune des bascules de balayage du premier ensemble comprenant une entrée d'activation de balayage (16) couplée au premier signal d'activation de balayage (31) ;
de désactiver le second signal d'activation de balayage (32) tout en continuant d'activer le premier signal d'activation de balayage (31) ; et
de lancer le premier motif de test ; et
de capturer des résultats depuis un second ensemble de bascules de balayage (112, 212, 312, 412, 512, 612) du circuit intégré (100, 200, 300, 400, 500, 600) en aval des premiers éléments logiques (126, 226, 526, 626) alors que le premier signal d'activation de balayage (31) est activé et le second signal d'activation de balayage (32) est désactivé, chacune des bascules de balayage du second ensemble comprenant une entrée d'activation de balayage (16) couplée au second signal d'activation de balayage (32).

12. Procédé selon la revendication 11, dans lequel le premier ensemble de bascules de balayage (111, 211, 311, 411, 511, 611) est une première chaîne de balayage (121, 221, 521, 621), et dans lequel le second ensemble de bascules de balayage (112, 212, 312, 412, 512, 612) est une seconde chaîne de balayage (122, 222, 522, 622) qui est séparée de la première chaîne de balayage (121, 221, 521, 621).

13. Procédé selon la revendication 12, dans lequel le circuit intégré (100, 200, 300, 400, 500, 600) comprend un circuit premier entré, premier sorti PEPS, dans lequel les bascules de balayage de la première chaîne de balayage (121, 221, 521, 621) sont configurées pour écrire dans le circuit PEPS, et dans lequel les bascules de balayage de la seconde chaîne de balayage (122, 222, 522, 622) comprennent un registre à décalage du circuit PEPS.

14. Procédé selon la revendication 12, dans lequel le circuit intégré (100, 200, 300, 400, 500, 600) comprend une chaîne de balayage de bascules de balayage (521, 621; 522, 622) comprenant un sous-ensemble du premier ensemble et un sous-ensemble du second ensemble, dans lequel les entrées d'activation de balayage de bascules de balayage adjacentes de la chaîne de balayage sont couplées à différents signaux d'activation de balayage.

15. Procédé selon la revendication 12, comprenant en outre :
de décaler un second motif de test dans le second ensemble de bascules de balayage (112, 212, 312, 412, 512, 612) tout en activant à la fois le premier signal d'activation de balayage (31) et le second signal d'activation de balayage (32), le second ensemble de bascules de balayage (112, 212, 312, 412, 512, 612) étant en amont de seconds éléments logiques (126, 226, 526, 626) du circuit intégré (100, 200, 300, 400, 500, 600) ;
de désactiver le premier signal d'activation de balayage (31) tout en continuant d'activer le second signal d'activation de balayage (32) ;
de lancer le second motif de test et de capturer des résultats depuis le premier ensemble de bascules de balayage (111, 211, 311, 411, 511, 611) alors que le premier signal d'activation de balayage (31) est désactivé et le second signal d'activation de balayage (32) est activé, le premier ensemble de bascules de balayage (111, 211, 311, 411, 511, 611) étant en aval des seconds éléments logiques (126, 226, 526, 626).
